Europäisches Patentamt

European Patent Office

Office européen des brevets

(19)

(11) Numéro de publication : **0 069 183**
**B1**

(12) **FASCICULE DE BREVET EUROPÉEN**

(45) Date de publication du fascicule du brevet :
18.09.85

(21) Numéro de dépôt : 81430018.2

(22) Date de dépôt : 25.06.81

(51) Int. Cl.⁴ : **H 03 K 19/173**// H04L25/12,
H03K19/23, H03K19/21,
H03K19/092

(54) **Procédé et dispositif pour transmettre des signaux logiques entre microplaquettes.**

(43) Date de publication de la demande :
12.01.83 Bulletin 83/02

(45) Mention de la délivrance du brevet :
18.09.85 Bulletin 85/38

(84) Etats contractants désignés :
DE FR GB

(56) Documents cités :
FR-A- 2 018 277
FR-A- 2 151 120
IEEE JOURNAL OF SOLID-STATE CIRCUITS, volume
SC-9, no. 5, octobre 1974 NEW YORK (US) B.A.
WOOLEY et al. "An integrated m-Out-of-n detection
circuit using threshold logic", pages 297-306

(73) Titulaire : International Business Machines Corporation
Old Orchard Road
Armonk, N.Y. 10504 (US)
DE GB
Compagnie IBM FRANCE
5 Place Vendôme
F-75000 Paris 1er (FR)
FR

(72) Inventeur : Brunin, Armand
61, allée de Bretagne
F-77350 Le Mee/Seine (FR)
Inventeur : d'Hervilly, Guy
4, résidence de la Theuillerie
F-91130 Ris-Orangis (FR)

(74) Mandataire : Lattard, Nicole
Compagnie IBM France Département de Propriété
Industrielle
F-06610 La Gaude (FR)

Jouve, 18, rue St-Denis, 75001 Paris, France

**0 069 183**

**Description**

Domaine Technique

La présente invention concerne un procédé et un dispositif pour transmettre des signaux logiques entre des microplaquettes de circuits intégrés à très haute densité, en réduisant le bruit provoqué par les liaisons entre microplaquettes.

Les microplaquettes de circuits intégrés développées actuellement permettent d'atteindre des densités très élevées et des vitesses elles aussi très élevées, dans le domaine des circuits logiques.

Les circuits logiques d'une première microplaquette réalisent une ou plusieurs fonctions sur des mots de données, et les mots de données du résultat doivent être transmis à une seconde microplaquette dans un ensemble pour subir d'autres traitements. Les données binaires sont représentées par des niveaux logiques haut ou bas qui dépendent généralement de l'état d'éléments semi-conducteurs : transistors bipolaires, transistors à effet de champ, diode, etc.

Un problème se pose lorsqu'il se produit une commutation simultanée de l'état bloqué à l'état conducteur, des éléments semi-conducteurs fournissant sur leurs sorties les signaux à transmettre par la première microplaquette (qui sera appelée microplaquette émettrice), par l'intermédiaire de ses bornes de sorties à la seconde microplaquette (qui sera appelée microplaquette réceptrice). En effet, la liaison entre chacune des sorties d'une microplaquette émettrice et l'entrée correspondante de l'autre microplaquette réceptrice a une capacité répartie non négligeable qui provoque des pointes de courant dans l'élément semi-conducteur connecté à cette sortie, lorsque cet élément devient conducteur. Il en résulte des perturbations dans les circuits de la microplaquette émettrice.

Une solution à ce problème consiste à éviter que les éléments semi-conducteurs fournissant les niveaux logiques aux sorties de la microplaquette émettrice commutent en même temps pour empêcher l'apparition simultanée des pointes de courant. Cette solution présente l'inconvénient de ralentir la transmission des signaux logiques entre microplaquettes et donc de dégrader le temps de réponse.

Une autre solution consisterait à utiliser des liaisons présentant des capacités réparties de valeurs négligeables. Mais c'est une solution qui ne peut être envisagée pour le moment compte tenu des technologies disponibles.

Dans des domaines techniques différents, par exemple dans le domaine des mémoires à tores, il est connu comme décrit dans le brevet français FR-A-2 151 120, d'inverser les bits des mots à écrire, dans certaines conditions, afin de réduire le pourcentage de zéros et de ce fait réduire la durée du cycle de lecture et d'inscription.

Objet de la Présente Invention

Un objet de la présente invention est donc un procédé permettant de réaliser la connexion de deux microplaquettes de circuits logiques intégrées de très haute densité avec un minimum de bruit.

Un objet de la présente invention est de réaliser un dispositif mettant en œuvre un tel procédé, ne dégradant pas les temps de réponse.

Résumé de la Présente Invention

La présente invention concerne donc un procédé pour transmettre N signaux logiques entre deux microplaquettes de circuits intégrés. La première microplaquette dite microplaquette émettrice a N bornes de sortie, et comporte au moins un ensemble de circuits logiques ayant N sorties sur lesquelles le (les) ensemble(s) génère(nt) les signaux logiques à transmettre de telle sorte que sur chacune desdites sorties le niveau logique du signal dépende de l'état conducteur ou bloqué d'un élément semi-conducteur. La seconde microplaquette comporte au moins N bornes d'entrée, connectées aux bornes de sortie de la microplaquette émettrice.

Le procédé comprend l'analyse de la configuration des niveaux logiques sur les N sorties du (des) ensemble(s) de circuits logiques pour générer une commande d'inversion si le nombre des niveaux logiques fournis par des éléments semi-conducteurs mis à l'état conducteur est supérieur à un nombre prédéterminé égal ou supérieur au nombre des niveaux logiques fournis par des éléments semi-conducteurs mis à l'état bloqué et pour générer une commande de transmission dans le cas contraire ; l'inversion de la configuration des signaux logiques fournis aux sorties du (des) ensemble(s) de circuits logiques et la transmission de cette configuration inversée aux entrées de la microplaquette réceptrice en réponse à la commande d'inversion ; la transmission directe de la configuration des signaux logiques fournis aux sorties du (des) ensemble(s) de circuits logiques aux entrées de la microplaquette réceptrice en réponse à la commande de transmission.

Les commandes d'inversion et de transmission sont transmises à la microplaquette réceptrice dans laquelle les signaux reçus sont inversés sous contrôle de la commande d'inversion.

Le dispositif conforme à la présente inversion est utilisé pour transmettre N signaux logiques entre deux microplaquettes de circuits intégrés, la microplaquette émettrice comportant au moins N bornes de sortie et au moins un ensemble de circuits logiques ayant N sorties sur lesquelles il(s) génère(nt) les

2

# 0 069 183

signaux logiques à transmettre de telle sorte que sur chacune desdites sorties, le niveau logique du signal à transmettre dépend de l'état conducteur ou bloqué d'un élément semi-conducteur et la microplaquette réceptrice comportant au moins N bornes d'entrée. Il comporte un moyen pour générer un signal de commande d'inversion/transmission ayant N entrées, chaque entrée étant connectée à une sortie du (des) ensemble(s) de circuits logiques et une sortie sur laquelle est généré un signal de commande d'inversion lorsque le nombre de niveaux logiques fourni par des éléments semi-conducteurs mis à l'état conducteur est supérieur à un nombre prédéterminé, égal ou supérieur aux nombres de niveaux logiques fournis par des éléments semi-conducteurs mis à l'état bloqué et pour générer un signal de commande de transmission dans le cas contraire ; N circuits d'attaque à inversion contrôlée ayant chacun une entrée de données connectée à une sortie du (des) ensemble(s) de circuits logiques et une entrée de commande recevant le signal de sortie du moyen pour générer le signal de commande d'inversion/transmission et une sortie connectée à une borne de sortie de la microplaquette émettrice sur laquelle le signal de l'entrée de données se retrouve inversée ou non suivant l'état du signal de commande.

Il peut comporter en outre, N liaisons électriques reliant les sorties de la microplaquette émettrice aux entrées de la microplaquette réceptrice et une (N + 1)ème liaison électrique ayant une entrée connectée à la sortie du circuit de génération du signal de commande d'inversion/transmission pour transmettre ledit signal à la microplaquette réceptrice. La microplaquette réceptrice comporte N circuits récepteurs à inversion contrôlée, chacun ayant une entrée de données connectée à la sortie d'une des N liaisons électriques, et une entrée de commande connectée à la sortie de la (N + 1)ème liaison électrique et une sortie sur laquelle le signal sur l'entrée de données se retrouve inversé ou non suivant l'état du signal de commande.

D'autres objets, caractéristiques et avantages de la présente invention ressortiront mieux de l'exposé qui suit, fait en référence aux dessins annexés à ce texte, qui représentent un mode de réalisation préféré de celle-ci.

La figure 1 illustre de façon très schématique le problème résolu par la présente invention.

La figure 2 représente le dispositif mettant en œuvre le procédé de la présente invention.

La figure 3 représente un circuit qui peut être utilisé comme circuit de génération du signal de commande inversion/transmission dans le dispositif de la figure 2.

La figure 4 représente un circuit qui peut être utilisé comme circuit d'attaque inverseur ou non dans le dispositif de la figure 2.

La figure 5 représente un circuit qui peut être utilisé comme circuit de réception inverseur ou non dans le dispositif de la figure 2.

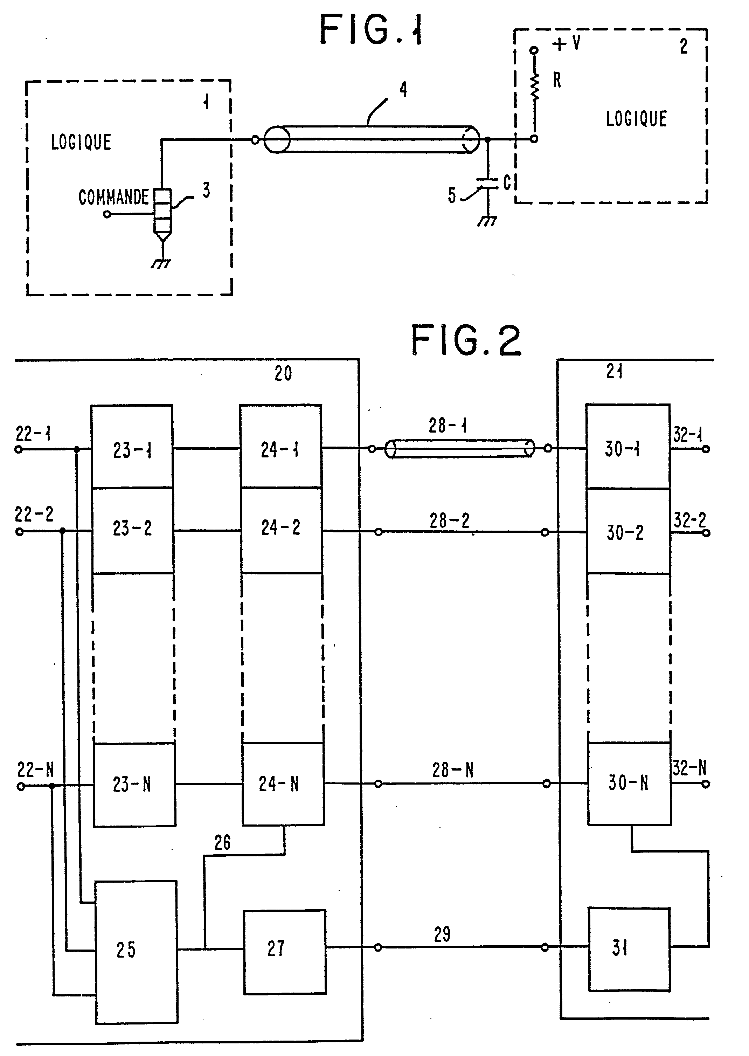

La figure 1 illustre de façon très schématique le problème que permet de résoudre la présente invention.

On suppose que l'on veuille transmettre au moyen d'une connexion classique, un signal logique d'une microplaquette 1 à une autre microplaquette 2. On a représenté à titre d'exemple le cas où l'élément semi-conducteur fournissant le signal à transmettre par la microplaquette est un transistor bipolaire NPN. Dans ce cas le niveau 0 est obtenu lorsque le transistor de sortie 3 de la microplaquette est conducteur. Le signal à transmettre est pris sur le collecteur de ce transistor dont l'état dépend d'une commande appliquée à sa base, résultant d'une opération logique réalisée sur la microplaquette. L'émetteur du transistor 3 est mis à la masse.

Le signal de sortie est transmis par une ligne de transmission, qui est représenté sous forme d'un câble coaxial 4 avec une capacité répartie 5. La résistance R connectée à une tension positive représente le circuit de contrôle d'entrée de la microplaquette 2.

Lorsqu'un niveau 0 est établi, le transistor 3 devient conducteur et du fait de la capacité 5 de la ligne il se produit une pointe de courant dans le transistor. Etant donné que la distribution de masse n'a pas une impédance négligeable, une variation de tension due à cette pointe de courant apparaît sur l'émetteur du transitor ce qui provoque des perturbations dans les circuits logiques dont la distribution de masse est associée à ce transistor.

Généralement, une microplaquette ne comporte pas qu'une seule sortie comme représenté sur la figure 1, mais une microplaquette de circuits logiques comporte plusieurs sorties, chacune correspondant à un bit d'un ou plusieurs mots binaires, en conséquence lorsque plusieurs transistors de sortie passent à l'état conducteur pour établir une configuration de données en sortie représentant un ou plusieurs mots binaires, les perturbations sont encore plus importantes.

Conformément à la présente invention ces perturbations sont réduites en réduisant le nombre de transistors devenant simultanément conducteurs.

Pour cela, la configuration des signaux logiques à transmettre est analysée pour générer un signal de commande d'inversion/transmission. Si parmi la configuration des signaux à transmettre de la microplaquette émettrice, le nombre de niveaux logiques correspondant à la mise à l'état conducteur d'éléments semi-conducteurs est supérieur à un nombre prédéterminé égal ou supérieur au nombre de niveaux logiques correspondant à la mise à l'état bloqué d'éléments semi-conducteurs, les signaux pris aux sorties des éléments semi-conducteurs sont transmis aux entrées de la microplaquette réceptrice, inversés. Dans le cas contraire ils sont transmis inchangés. Les signaux reçus par la microplaquette sont inversés avant d'être traités par la logique de la microplaquette s'ils avaient été transmis inversés et ils sont utilisés sans être modifiés dans le cas contraire.

3

De cette façon quelle que soit la configuration de signaux à transmettre le nombre d'éléments semi-conducteurs qui passeront à l'état conducteur sera toujours inférieur ou égal au nombre d'éléments qui passeront à l'état bloqué.

On va maintenant décrire en référence à la figure 2 un dispositif pour mettre en œuvre ce procédé. On prendra pour hypothèse que le passage d'un élément semi-conducteur tel qu'un transistor NPN à l'état conducteur fournit en sortie un niveau bas 0 et que le passage à l'état bloqué fournit un niveau haut 1. Il est bien entendu que d'autres conventions peuvent être adoptées suivant le type d'élément semi-conducteur et sa disposition par rapport aux tensions d'alimentation.

Les signaux logiques à transmettre par la microplaquette émettrice 20, pris aux bornes d'éléments semi-conducteurs 22-1 à 22-N, sont appliqués par l'intermédiaire de circuits de compensation de retard 23-1 à 23-N qui ne changent pas la phase des signaux d'entrée, à des circuits d'attaque 24-1 à 24-N. Les signaux sur les bornes 22-1 à 22-N sont analysés par le circuit 25 de génération d'un signal d'inversion/transmission. Ce circuit 25 reçoit les N signaux de sortie et génère un signal de commande qui est appliqué aux circuits d'attaque par la ligne 26 et qui est transmis hors de la microplaquette par un circuit d'attaque 27.

Si le nombre de 0 est plus grand que le nombre de 1, le circuit 25 génère un signal de commande d'inversion sur la ligne 26 qui est actif pour commander l'inversion des signaux par les circuits 24-1 à 24-N. Si le nombre de 1 est plus grand que le nombre de 0 le circuit 25 génère un signal de commande de transmission qui ne provoque pas d'inversion des signaux de sortie par les circuits d'attaque.

Dans le cas où N est pair, c'est-à-dire qu'il peut y avoir un nombre de 1 égal au nombre de 0, l'état du signal de commande est pris en compte pour déterminer si la configuration doit être transmise inversée ou inchangée comme cela sera décrit ultérieurement.

La liaison entre les bornes de sortie de la microplaquette émettrice 20 et les bornes d'entrée de la microplaquette réceptrice 21 est effectuée par des lignes qui peuvent être des lignes coaxiales, 28-1 à 28-N et 29. Ces lignes transmettent les signaux de sortie des circuits d'attaque aux entrées de circuits de réception 30-1 à 30-N. La ligne 29 transmet le signal de commande inversion/transmission à un récepteur 31 qui applique ce signal de commande aux circuits de réception pour que les signaux reçus par ces circuits soient inversés ou non suivant l'état du signal de commande. Les sorties 32-1 à 32-N des récepteurs fournissent donc des signaux qui reflètent exactement les niveaux logiques sur les bornes 22-1 à 22-N.

En conséquence grâce à cette disposition il y aura toujours, avec les conventions logiques utilisées, moins de transistors de sortie dans les circuits d'attaque 24-1 à 24-N qui passeront de l'état bloqué à l'état conducteur, que de transistors qui passeront de l'état conducteur à l'état bloqué. Le cas le plus défavorable se produit lorsqu'il y a autant de 0 que de 1 dans la configuration des signaux de sortie sur les bornes 22-1 à 22-N.

La génération du signal de commande inversion/transmission par le circuit 25 nécessitant un temps t, les circuits de compensation de retard 23-1 à 23-N introduisent un retard t correspondant dans les signaux sur les bornes 22-1 à 22-N pour que le signal de commande sur la ligne 26 soit bien présent lorsque les données arrivent à l'entrée des circuits d'attaque.

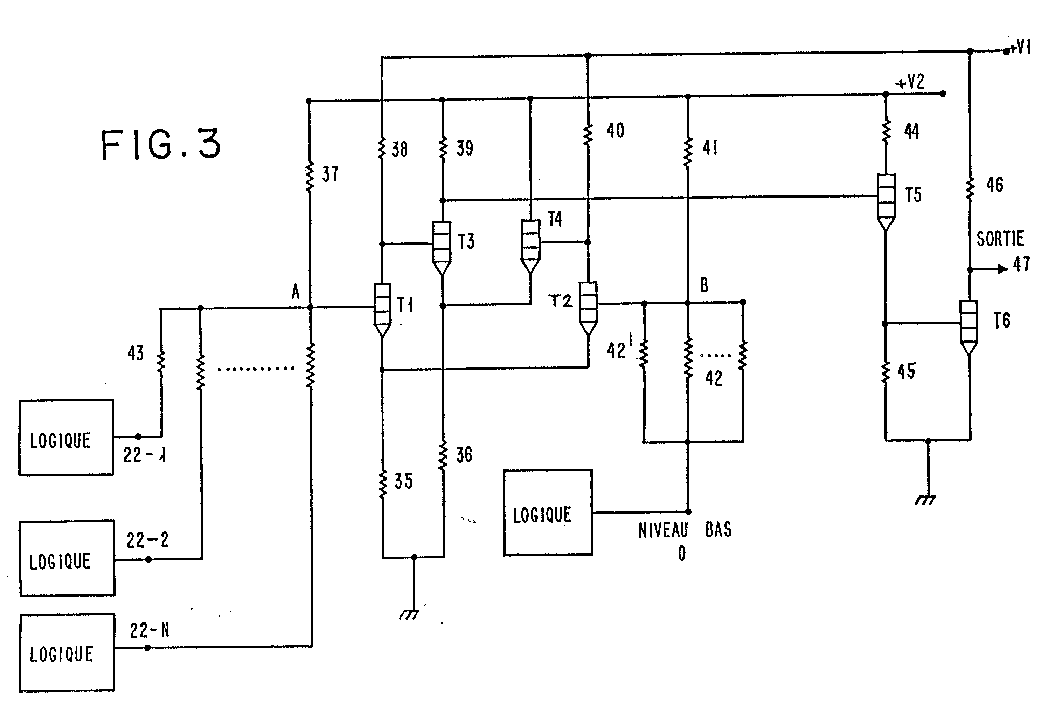

Le dispositif représenté sur la figure 2 peut être réalisé de différentes façons. On va décrire en référence aux figures 3, 4 et 5 des circuits qui peuvent être utilisés comme circuits de génération du signal de commande d'inversion/transmission 25, comme circuit d'attaque à inversion contrôlée 24-1 à 24-N et comme circuit de réception à inversion contrôlée 30-1 à 30-N. Les autres circuits 27, 29, 31 et 23-1 à 23-N sont des circuits classiques qui ne seront pas décrits en détail.

Dans un mode de réalisation préféré le circuit de génération du signal de commande inversion/transmission comprend un amplificateur différentiel constitué des transistors T1, T2, T3, T4 et des résistances 35 à 41. Les émetteurs des transistors T1 et T2 sont reliés ensemble et connectés à la masse par la résistance 35. Les émetteurs des transistors T3 et T4 sont reliés ensemble et connectés à la masse par la résistance 36. Les collecteurs des transistors T1 et T2 sont connectés par les résistances 38 et 40 à une première alimentation de tension + V1 qui est dans le mode de réalisation préféré égale à 1,7 volts, ils sont aussi connectés aux bases des transistors T3 et T4. Les collecteurs des transistors T3 et T4 sont connectés à une seconde alimentation de tension + V2 qui dans un mode de réalisation préféré est égale à 3,4 volts.

Les tensions à comparer par l'amplificateur différentiel sont générées sur les bases des transistors T1 et T2 aux nœuds A et B respectivement. Des résistances 42 dont le nombre varie suivant que N est pair ou impair, comme cela sera expliqué par la suite, sont disposées en parallèle entre le nœud B et un circuit logique générant un niveau de tension correspondant au niveau bas (niveau 0) de signaux de données sur les bornes de sortie 22-1 à 22-N (figure 2) fournissant les signaux à transmettre par la microplaquette émettrice.

N résistances 43 sont montées en parallèle entre le nœud A, nœud commun, et chacune des bornes de sortie 22-1 à 22-N sur lesquelles sont générées par des circuits logiques de la microplaquette émettrice, les signaux logiques à transmettre à la microplaquette réceptrice.

Un circuit de sortie, comprenant deux transistors T5 et T6 et trois résistances 44 à 46, fournit le signal de commande inversion/transmission sur la sortie 47. Le transistor T5 a sa base connectée au collecteur du transistor T3, son collecteur connecté par la résistance 44 à la tension + V2 et son émetteur connecté à la masse par la résistance 45. Le transistor T6 est monté de la façon suivante : sa base est connectée à l'émetteur du transistor T5, son collecteur connecté à la tension d'alimentation + V1 par une résistance 46 et son émetteur mis à la masse. Le signal de commande d'inversion/transmission est pris au collecteur du transistor T6.

On va maintenant décrire le fonctionnement de ce circuit.

On va d'abord supposer N pair pour avoir le minimum de 0 en sortie des circuits 24 et 27 dans l'hypothèse où le circuit 27 n'inverse pas, le circuit 25 change d'état pour un nombre de 1 sur les entrées 22-1 à 22-N variant de N/2 à N/2 + 1. Cela correspond à un nombre de courant dans les résistances 43 variant de N/2 à (N/2)-1. L'on disposera donc (N/2)-1 résistances 42 avec en parallèle une résistance supplémentaire 42' dont la valeur est égale à deux fois celle des résistances 42 pour créer un déséquilibre et que les niveaux en A et B ne soient pas égaux. On choisit R37/R43 = R41/R42. Dans ces conditions, la tension entre les nœuds A et B change de sens quand le nombre de 1 passe de N/2 à (N/2) + 1 et inversement changeant le niveau logique sur la sortie 47. Le nombre maximum de 0 en sortie des circuits 24 et 27 est alors égal à N/2.

Donc, si le nombre de 0 sur les bornes 22-1 à 22-N est égal ou supérieur au nombre de 1, le nœud A est à une tension inférieure à celle du nœud B. En conséquence, le transistor T2 conduit et le transistor T1 est bloqué. Les transistors T3 et T4 sont de ce fait respectivement conducteur et bloqué. Dans le circuit de sortie les transistors T5 et T6 sont bloqués et il en résulte que le signal sur la sortie 47 est au niveau haut, et il sera utilisé pour commander l'inversion des signaux à transmettre par la microplaquette émettrice.

Inversement, si le nombre de 0 est inférieur au nombre de 1, le transistor T3 sera bloqué et donc le transistor T5 est conducteur et le niveau de sortie en 47 est au niveau bas et il sera utilisé pour commander la transmission inchangée des signaux de sortie.

Si N est impair, pour avoir le minimum de 0 en sortie des circuits 24 et 27, toujours dans l'hypothèse où 27 n'inverse pas, le circuit 25 change d'état pour un nombre de 1 sur les entrées 22-1 à 22-N variant de (N-1)/2 à (N + 1)/2. Cela correspond à un nombre de courant dans les résistances 43 variant de (N + 1)/2 à (N-1)/2. L'on disposera donc (N-1)/2 résistances 42 avec en parallèle une résistance 42' dont la valeur est égale à deux résistances 42, avec R37/R43 = R41/R42. Dans ces conditions, la tension entre les nœuds A et B change de sens quand le nombre de 1 passe de (N-1)/2 à (N + 1)/2 et inversement, changeant le niveau logique sur la sortie 47. Le nombre maximum de 0 en sortie des circuits 24 et 27 est égal à (N + 1)/2.

Le signal de commande est généré à un niveau haut (commande d'inversion) si le nombre de 0 est égal ou supérieur à (N + 1)/2. Si le nombre de 0 est inférieur à (N + 1)/2 le signal de commande est généré à un niveau bas (commande de transmission).

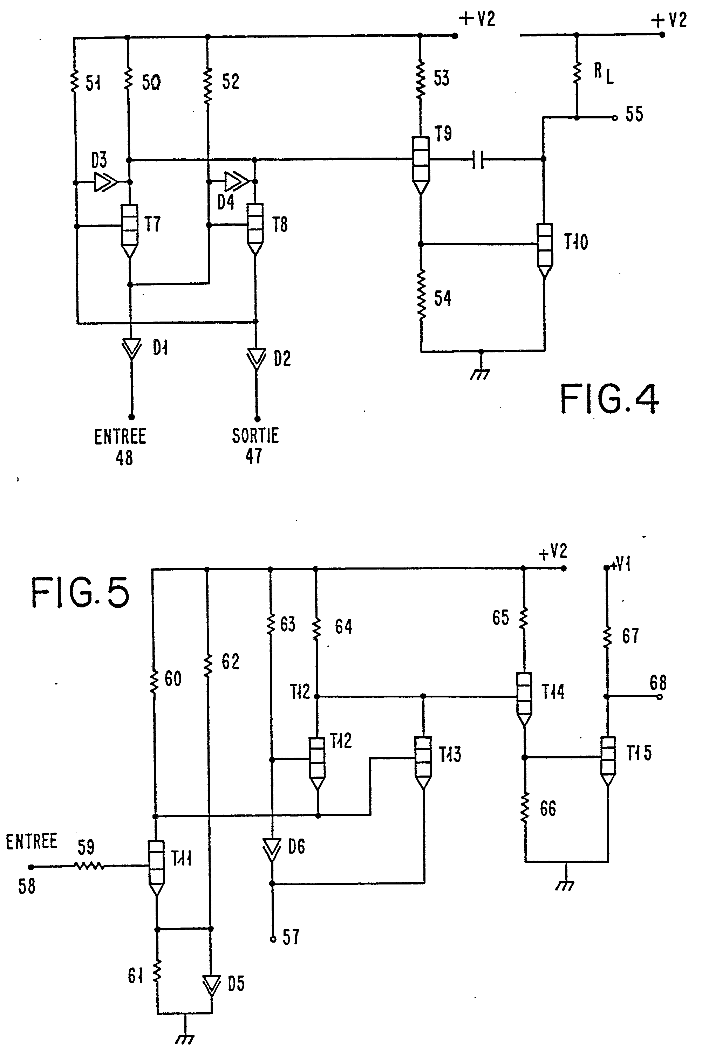

On va décrire en référence à la figure 4 un circuit d'attaque à inversion contrôlée qui peut être utilisé dans chacun des étages 24-1 à 24-N pour transmettre les signaux sur les bornes 22-1 à 22-N inversés ou inchangés suivant l'état du signal de commande d'inversion/transmission.

Ce circuit comprend quatre transistors T7 à T10. L'émetteur du transistor T7, connecté à la sortie d'un étage de compensation du retard 23-i, reçoit donc le signal de sortie de la microplaquette émettrice, retardée, par l'intermédiaire d'une diode de Schottky D1.

L'anode de diode de Schottky D1 est connectée à l'émetteur du transistor T7 et sa cathode est connectée à l'étage de compensation de retard 23-i (23-i signifiant un des étages 23-i à 23-N) à la borne d'entrée 48.

Le collecteur du transistor T7 est connecté à la tension + V2 par une résistance 50.

Le transistor T8 a son émetteur connecté par une diode de Schottky D2 à la sortie 47, qui reçoit le signal de commande inversion/transmission. L'anode de la diode D2 est connectée à l'émetteur du transistor T8, sa cathode est connectée à la borne 47. Le collecteur du transistor T8 est connecté par la résistance 50 à la tension d'alimentation + V2.

D'autre part, l'émetteur du transistor T8 est connecté à la base du transistor T7 et à la tension + V2 par une résistance 51. L'émetteur du transistor T7 est connecté à la base du transistor T8 et à la tension + V2 par une résistance 52. Deux diodes de Schottky d'antisaturation D3 et D4 sont disposées entre les collecteurs et bases des transistors T7 et T8 respectivement.

Les collecteurs des transistors T7 et T8 sont connectés à la base du transistor T9 dans l'étage de sortie. Cet étage comprend les transistors T9 et T10. Le collecteur du transistor T9 est connecté par une résistance 53 à la tension d'alimentation + V2. Son émetteur est connecté d'une part à la base du transistor T10 et d'autre part à la masse par la résistance 54. L'émetteur du transistor T10 est connecté à la masse et son collecteur à une borne de sortie 55, qui sera connectée à la ligne de transmission 28-i.

Le fonctionnement de ce circuit est le suivant : si le signal de commande inversion/transmission sur la borne 47 est à 0, ce qui correspond à une transmission du signal d'entrée 48, inchangé, la diode D2 est conductrice. Si le signal en 48 est à 0, la diode D1 est aussi conductrice et les deux transistors T7 et T8 sont bloqués. Les transistors T9 et T10 sont conducteurs et le signal de sortie sur la borne 55 du fait de l'impédance de charge RL est 0. Si le signal en 48 est à 1, la diode D1 est bloquée, le transistor T8 est conducteur et donc les transistors T9 et T10 sont bloqués et la sortie est à 1. Dans cette condition, les signaux d'entrée en 48 se retrouvent en sortie avec le même niveau logique.

Inversement, si le signal de commande inversion/transmission est à 1, la diode D2 est bloquée. Si le signal en 48 est à 0, la diode D1 est conductrice, le transistor T7 est conducteur.

Donc les transistors T9 et T10 sont bloqués et le signal de sortie est au niveau 1. Si le signal en 48 est à 1, la diode D1 est bloquée ainsi que les transistors T7 et T8. Les transistors T9 et T10 sont conducteurs et le signal de sortie en 55 est à 0. Dans cette condition, les signaux à la sortie 55 correspondent bien aux signaux d'entrée (en 48) inversés.

Le circuit comprenant les transistors T7 et T8 est en fait un circuit OU Exclusif.

On va maintenant décrire en référence à la figure 5, un circuit de réception qui peut être utilisé dans chacun des étages 30-i de la figure 2.

Le signal de commande d'inversion/transmission est reçu du circuit 31 sur la borne de commande 57. Le signal de la ligne 28-i est reçu sur la borne d'entrée 58.

Le signal d'entrée sur la borne 58 est appliqué par une résistance 59 à la base d'un transistor d'entrée T11. Le transistor est polarisé par la résistance 60 connectée entre son collecteur et la tension V2, par la résistance 61 et la diode D5 montée en parallèle entre l'émetteur et la masse, la cathode est reliée à la masse. Le point commun entre l'anode de la diode D5 et la résistance 61 est connecté par une résistance 62 à la tension V2.

La borne d'entrée 57 est connectée à la cathode d'une diode D6 dont l'anode est connectée à la base d'un transistor T12. La base du transistor T12 est connectée par la résistance 63 à la tension + V2 et son collecteur est connecté par la résistance 64 à la tension + V2. Son émetteur est connecté au collecteur du transistor d'entrée T11. La borne de commande 57 est connectée à l'émetteur du transistor T13, dont la base est connectée à l'émetteur du transistor T12 et le collecteur au collecteur du transistor T12. Le point commun aux collecteurs des transistors T12 et T13 est connecté à un étage de sortie comprenant deux transistors T14 et T15. Le transistor T14 a son collecteur connecté par une résistance 65 à la tension + V2 et son émetteur connecté par une résistance 66 à la masse. Le transistor T15 est un transistor dont la base est connectée à l'émetteur du transistor T14, l'émetteur est connecté à la masse, et le collecteur est connecté par une résistance 67 à la tension + V1.

On supposera que l'on désire retrouver sur les sorties 32-1 à 32-N des signaux correspondant aux signaux d'entrée 22-1 à 22-N, pour cela le circuit 31 inverse le signal reçu du circuit 27.

Le fonctionnement de ce circuit est le suivant. Lorsque l'entrée de commande 57 est au niveau bas, la diode D6 est conductrice, le signal reçu en 58 est inversé, en sortie 68 au collecteur du transistor T15. Si l'entrée 58 est à 1, niveau haut, le transistor T11 est conducteur, le transistor T12 est bloqué et le transistor 13 est bloqué, donc les transistors T14 et T15 sont conducteurs et le signal de sortie est au niveau bas, représentant un 0 logique. Si l'entrée 58 est à 0, niveau bas, le transistor T11 est bloqué, le transistor T12 est bloqué, le transistor T13 est conducteur. Les transistors T14 et T15 sont bloqués et la tension de sortie en 68 est au niveau haut : 1.

Inversement lorsque l'entrée de commande 57 est au niveau haut, la diode D6 est bloquée, le signal reçu en 58 se retrouve inchangé à la sortie 6. Si l'entrée 58 est à 1, le transistor T11 est conducteur, le transistor T12 est conducteur et T13 est bloqué et donc la sortie en 68 est au niveau haut : 1. Si l'entrée 58 est à 0, le transistor T11 est bloqué. Le transistor T12 est bloqué et le transistor T13 est bloqué. Les transistors de sortie sont donc conducteurs et la sortie en 68 est au niveau bas : 0.

Il est évident que dans une autre hypothèse où l'on désire que les signaux 32-1 à 32-N soient les inverses des signaux 22-1 à 22-N, on peut s'arranger pour que le signal de commande inversion/transmission agisse en sens contraire.

Le circuit 25 peut être réalisé sous la forme d'un circuit logique fondé sur le principe connu d'une porte logique de majorité. Ces circuits peuvent être construits à partir de PLA (Programmable Logic Array).

La représentation de tels circuits étant très compliquée on va donner les données théoriques qui permettront à un homme de l'art de réaliser le circuit 25 dans différentes hypothèses. En effet, la réalisation de ce circuit logique implique de résoudre un problème d'optimisation à plusieurs paramètres variant en sens contraire.

Avant de commencer la description on va donner quelques définitions indispensables.

Que des fils de liaison, de circuit intégré à circuit intégré, soient des commandes (ou contrôles) ou des données, ils sont toujours plus ou moins groupés en faisceaux ordonnés, c'est-à-dire en SEQUENCES de BITS. On notera N, le nombre générique d'une séquence de bits à transporter d'un circuit intégré à un autre.

On va considérer, ici, le cas d'une implantation du circuit 25 en logique négative, c'est-à-dire :

$$\rightarrow 0 = \text{ligne ACTIVE,}$$
$$\rightarrow 1 = \text{ligne au REPOS}$$

Si on répartit toutes les sorties (« pins » en anglais) d'un circuit intégré en séquences de N bits, le taux d'accroissement du nombre de sorties, dû au dispositif, et noté «$\Delta$pin », vaut :

$$\rightarrow \Delta\text{pin} = 1 \div N.$$

On notera TR le taux de repos d'un TYPE de séquences, c'est-à-dire sa proportion de bits inactifs. On dira précisément que deux séquences de N bits sont de même type si, et seulement si, elles ont le même TR. On va considérer, par exemple, toutes les séquences de N = 5 bits dont M = 3 inactifs :

→ 00111,
→ 01011,
→ 01101,
→ 01110,
→ 10011,
→ 10101,
→ 10110,
→ 11001,
→ 11010,
→ 11100.

Si (M ! N) (lire « M parmi N ») désigne le nombre de combinaisons sans répétitions, d'ordre M, réalisables à partir de N objets, les séquences précédentes sont au nombre de (M ! N) = (N−M)!N = 3!5 = 2!5 = 10 et sont toutes du même type, à savoir :

$$TR = 3 \div 5 = 60\%$$

On réalisera l'implantation logique du circuit 25 à l'aide d'une PLA, dont on identifiera le nombre MT de MIN-TERMES (c'est-à-dire de termes-produits) au nombre de circuits logiques. On appellera alors TAUX de CIRCUITS, noté TC, d'une séquence de bits, le rapport TC = MT ÷ (N + 1) du nombre de circuits additionnels (nécessités par le dispositif 25) au nombre total de liaisons finales (c'est-à-dire les N bits de la séquence plus le bit de contrôle 26 engendré par ce même dispositif 25 et commandant l'inversion ou la transmission de la séquence à transporter).

Le paramètre TR lui-même conduit en fait à trois nouveaux paramètres distincts et notés :
→ ITR = TR de la Séquence Initiale, c'est-à-dire sans tenir compte ni du dispositif 25, ni du bit additionnel de commande 26.
→ JTR = TR de la Séquence Finale, dont en tenant compte du dispositif 25 ainsi que des circuits 24-1 à 24-N mais sans prendre en compte la liaison additionnelle 29 ; (JTR est donc directement comparable à ITR en matérialisant le gain obtenu sur ce paramètre par l'introduction du dispositif 25).
→ KTR = TR global de la Séquence Finale totale donc tenant compte à la fois du dispositif 25 et des circuits 24-1 à 24-N ainsi que de la liaison additionnelle de contrôle 29. (KTR est bien le TR global finalement obtenu).

Chacun des trois paramètres précédents, que l'on peut noter XTR (avec X = I, J ou K), se définit en fait pour chaque type de séquences initiales et donc pour chaque séquence initiale elle-même. Par suite on peut introduire les six nouveaux paramètres suivants, qui seront utilisés :
→ mXTR = XTR minimum de toutes les séquences initiales possibles (avec X = I, J ou K).
→ μXTR = XTR statistiquement moyen sur toutes les séquences initiales possibles (avec toujours X = I, J ou K).

Après toutes ces difinitions essentielles, la position du problème à résoudre consiste à trouver un optimum correspondant simultanément à :
→ une minimisation de Δpin ; (on peut s'attendre dans les prochaines années à des puces VLSI avec 200 à 400 entrées/sorties, n'autorisant pas plus de 20 à 50 sorties « perdues » pour la logique au profit du dispositif de la présente invention : soit une limite raisonnable de Δpin ≃ 10 à 15 %),
→ une minimisation de TC ; (les prochaines années verront des puces à 15 000 ou 30 000 circuits pour 200 à 400 entrées/sorties, n'autorisant, pour la réalisation des circuits 25, guère plus de 2 000 circuits pour 400 pins, ce qui conduit à une limite approximative de TC ≃ 5 circuits/pin),
→ μITR < μJTR : une maximalisation de μJTR, paramètre directement comparable à μITR ; mais en fait, maximalisation de μKTR, seul véritable paramètre obtenu en définitive. Les limites à se fixer pour les deux paramètres précédents (μJTR et μKTR) découle de la propriété suivante :

On appelle SI(N) l'ensemble de toutes les Séquences Initiales logiques à N bits, SJ(N) l'ensemble de toutes les Séquences Finales Restreintes qui en découlent, (c'est-à-dire avec les seuls N bits de données transformés par 24-1 à 24-N donc en excluant le bit additionnel de commande 26 transmis par la liaison 29), et enfin SK(N) l'ensemble de toutes les Séquences Finales Totales à N + 1 bits (les N bits transformés par 24-1 à 24-N et le bit additionnel de commande transmis par 29). Avec la terminologie précédente, QUEL QUE SOIT le nombre naturel positif N, on a toujours les propriétés du Tableau I.

Tableau I

| mITR(N) | = | 0 | et 50% des SI(N) ont un |
| ITR | ≥ | 50 % | avec une moyenne de |
| μITR(N) | = | 50 % | |

7

Ceci signifie que le minimum de TR sur toutes les SI(N) est nul donc très défavorable ; de plus la moitié seulement des SI(N) ont un TR dépassant 50 % ; enfin le TR moyen de toutes les SI(N) n'est lui-même que de 50 %.

On peut donc déjà fixer les objects suivants :

m KTR(N) > mJTR(N) > 0,

plus de 50 % SJ(N) ont un JTR $\geqslant$ 50 %,

plus de 50 % SK(N) ont un KTR $\geqslant$ 50 %, avec :

$\mu$KTR(N) > $\mu$JTR(N) > 50 %.

On va traiter complètement le cas N = 4 en exemple pour montrer tous les mécanismes du raisonnement ; on traitera ensuite plus rapidement le cas où le nombre est impair avec l'exemple N = 5 ; on appliquera alors les résultats généraux tirés de ces deux exemples aux deux cas que l'on rencontre le plus souvent : N = 8 et N = 9 en faisant une extension possible par analogie.

Traitement complet du cas N = 4 : Soit p le nombre total de toutes les séquences initiales à 4 bits, c'est-à-dire le nombre cardinal de SI(N) ; on a :

$$P = 2 \text{ ✗ } N = 2 \text{ ✗ } 4 = 16 \text{ (✗ : opérateur d'exponentiation)}$$

réparties en N + 1 = 4 + 1 = 5 types de 0 à N :

Tableau II

| | | | |
|---|---|---|---|
| (4!4) = 1 | du type 4 | : | 1 1 1 1 ; |
| (3!4) = 4 | du type 3 | : | 0 1 1 1 , |
| | | | 1 0 1 1 , |
| | | | 1 1 0 1 , |
| | | | 1 1 1 0 ; |
| (2!4) = 6 | du type 2 | : | 0 0 1 1 , |
| | | | 0 1 0 1 , |
| | | | 0 1 1 0 , |
| | | | 1 0 0 1 , |
| | | | 1 0 1 0 , |
| | | | 1 1 0 0 ; |
| (1!4) = 4 | du type 1 | : | 0 0 0 1 , |
| | | | 0 0 1 0 , |
| | | | 0 1 0 0 , |
| | | | 1 0 0 0 ; |
| (0!4) = 1 | du type 0 | : | 0 0 0 0 |

Les TYPES de séquences eux-mêmes peuvent se classer en deux catégories :

catégorie des types de séquences avec TR $\geqslant$ 50

catégorie des types de séquences avec TR < 50

Dans le cas particulier, comme ici, où N est PAIR, on peut même envisager trois catégories :

TR > 50 %,

TR = 50 %,

TR < 50 %.

Exemples

TR (1101) = TR (3, 4) = (3 ÷ 4) = 75 %

TR (1010) = TR (2, 4) = (2 ÷ 4) = 50 %

TR (0000) = TR (0, 4) = (0 ÷ 4) = 0 %.

**0 069 183**

On constate alors immédiatement le résultat suivant en trois points :

0. La solution du problème à résoudre est simple : inverser tous les bits des seules séquences initiales à TR trop bas et qui, du fait même de cette inversion, obtiennent un TR supérieur ; (l'inversion d'une séquence donne en effet : TR' = 1-TR).

1. Si on inverse tous les bits d'une séquence quelconque de la catégorie TR > 50 %, on obtient une séquence de la catégorie TR < 50 %, une telle transformation doit être proscrite puisque nuisible au but recherché.

2. Si on transforme de même une séquence quelconque de la catégorie TR = 50 %, on obtient une autre séquence de la MEME catégorie ; une telle transformation doit être proscrite comme inutile au but recherché.

3. Si on effectue enfin la même opération sur une séquence quelconque d'une catégorie TR < 50 %, on obtient une séquence d'une catégorie TR > 50 % ; ce genre de transformations doit systématiquement être retenu car il contribue seul au but recherché d'augmenter le plus possibles les TR.

Aspect LOGIQUE du problème : En suivant le procédé de transformation défini précédemment, on peut ré-écrire toutes les séquences du tableau II en les faisant toutes suivres du bit 26 dit d'INVERSION/TRANSMISSION de commande (de transformation) en raccourci. Ce bit de commande suit la convention de logique suivante :

1 = REPOS → TRANSMISSION ;

0 = ACTIF → INVERSION.

Le résultat, présenté sur le tableau III, n'est pas autre chose que la table de vérité du circuit 25 :

Tableau III

| | | |
|---|---|---|
| 1 1 1 1 | : | 1 |
| 0 1 1 1 | : | 1 |
| 1 0 1 1 | · | 1 |
| 1 1 0 1 | : | 1 |
| 1 1 1 0 | : | 1 |
| 0 0 1 1 | : | 1 |
| 0 1 0 1 | : | 1 |
| 0 1 1 0 | : | 1 |
| 1 0 0 1 | : | 1 |
| 1 0 1 0 | : | 1 |
| 1 1 0 0 | : | 1 |
| 0 0 0 1 | : | 0 |
| 0 0 1 0 | : | 0 |
| 0 1 0 0 | : | 0 |
| 1 0 0 0 | : | 0 |
| 0 0 0 0 | : | 0 |

Pour être plus facilement exploitable, on peut compacter cette table de vérité en un diagramme de Karnaugh comme l'indique le tableau IV.

(Voir Tableau IV page suivante)

9

Tableau IV

```
                        Y
        0     0     1     1     C
        0     1     1     0     D
  ========================================
  0  0  ( 0     0 )        0
  0  1  0
> ----x
  1  1
  1  0  0
  ========================================
  A  B
```

En appelant A, B, C, D les N = 4 fils 22-1 à 22-N, la théorie logique des implicants principaux conduit alors à la fonction d'inversion/transmission suivante (IT) :

$$\overline{IT} = \bar{A}\,\bar{B}\,(\bar{C} + \bar{D}) + \bar{A}\,(\bar{C}\,\bar{D}) + 0 + \bar{B}\,(\bar{C}\,\bar{D})$$

l'écriture précédente respecte l'ordre ligne à ligne des implicants principaux du diagramme du tableau IV. C'est une somme logique de $(3\,!\,4) = 4$ produits, précisément ceux qui indiquent les séquences à inverser

$\bar{A}\,\bar{B}\,\bar{C} \rightarrow 0001,$
$\bar{A}\,\bar{B}\,\bar{D} \rightarrow 0010,$
$\bar{A}\,\bar{C}\,\bar{D} \rightarrow 0100,$
$\bar{B}\,\bar{C}\,\bar{D} \rightarrow 1000.$

N.B. : Au point de vue de l'optimalisation logique, il est parfaitement inutile de considérer la séquence 0000 car le produit correspondant $\bar{A}\,\bar{B}\,\bar{C}\,\bar{D}$ est déjà traité dans la somme des produits précédents, comme l'indique les deux cases encerclées du tableau IV :

$$\bar{A}\,\bar{B}\,\bar{C} = \bar{A}\,\bar{B}\,\bar{C}\,D + \bar{A}\,\bar{B}\,\bar{C}\,\bar{D}$$

L'assimilation du nombre de circuits impliqués au nombre de termes-produits conduit au taux de circuits suivants :

Tc = (3 ! 4) pour cinq sorties finales,
   = 4 ÷ 5,
   = 0 · 8 circuit/pin, < 5 donc très bon.

La génération de cette formule à un nombre pari quelconque $N = 2 \times M$ devient :

TC = (1 + N ÷ 2) !N pour N + 1 sorties finales,
   = ((1 + N ÷ 2) !N) ÷ (N − 1).

Le taux d'accroissement du nombre des sorties s'avère prohibitif pour N = 4 :

$$\triangle pin = 1 \div 4 = 25\,\%, \; > 10 \text{ à } 15\,\%.$$

Si on recopie le tableau III en ajoutant les fils de liaison 28-1 à 28-N, c'est-à-dire après la prise en compte des inversions/transmissions, à la droite du fil de commande. L'examen du résultat, écrit sur le tableau VI montre les propriétés suivantes :

# 0 069 183

Tableau V

| |
|---|
| mJTR = 50%, donc 100% des SJ(N) ont un |
| JTR $\geq$ 50% avec une moyenne de |
| $\mu$JTR = 69%. |

à comparer au résultat général du tableau I.

Tableau VI

| | | | | | | | |
|---|---|---|---|---|---|---|---|
| 1 | 1 | 1 | 1 | , 1 | 1 | 1 | 1 | 1 |
| 0 | 1 | 1 | 1 | , 1 | 0 | 1 | 1 | 1 |
| 1 | 0 | 1 | 1 | , 1 | 1 | 0 | 1 | 1 |
| 1 | 1 | 0 | 1 | , 1 | 1 | 1 | 0 | 1 |
| 1 | 1 | 1 | 0 | , 1 | 1 | 1 | 1 | 0 |
| 0 | 0 | 1 | 1 | , 1 | 0 | 0 | 1 | 1 |
| 0 | 1 | 0 | 1 | , 1 | 0 | 1 | 0 | 1 |
| 0 | 1 | 1 | 0 | , 1 | 0 | 1 | 1 | 0 |
| 1 | 0 | 0 | 1 | , 1 | 1 | 0 | 0 | 1 |
| 1 | 0 | 1 | 0 | , 1 | 1 | 0 | 1 | 0 |
| 1 | 1 | 0 | 0 | , 1 | 1 | 1 | 0 | 0 |
| 0 | 0 | 0 | 1 | , 0 | 1 | 1 | 1 | 0 |
| 0 | 0 | 1 | 0 | , 0 | 1 | 1 | 0 | 1 |
| 0 | 1 | 0 | 0 | , 0 | 1 | 0 | 1 | 1 |
| 1 | 0 | 0 | 0 | , 0 | 0 | 1 | 1 | 1 |
| 0 | 0 | 0 | 0 | , 0 | 1 | 1 | 1 | 1 |

Enfin, le résultat global, réellement obtenu, est encore meilleur.

Tableau VII

| |
|---|
| mKTR = 60% et 100% des SKN ont un |
| KTR $\geq$ 60% > 50% avec une moyenne de |
| $\mu$KTR = 69% |

à comparer aux tables I et VI.

Les résultats statistiques et le compte de circuit sont excellents mais le taux d'accroissement du nombre de circuits, qui est assez élevé, empêche d'utiliser ce cas d'une manière systèmatique et limite son utilisation à deux ou trois faisceaux de quatre fils.

Traitement du cas N = 5 :

Le tableau VIII est semblable à la combinaison des tableaux II, III et V ; de plus on n'écrira plus qu'une seule séquence par type :

11

## 0 069 183

Tableau VIII

```
(5!5) =  1 du type 5 :  1 1 1 1 1  ,  1    1 1 1 1 1
(4!5) =  5 du type 4 :  0 1 1 1 1  ,  1    0 1 1 1 1
(3!5) = 10 du type 3 :  0 0 1 1 1  ,  1    0 0 1 1 1
(2!5) = 10 du type 2 :  0 0 0 1 1  ,  1    0 0 0 1 1
(1!5)' =  5 du type 1 :  0 0 0 0 1  ,  0    1 1 1 1 0
(0!5) =  1 du type 0 :  0 0 0 0 0  ,  0    1 1 1 1 1
              32 = 2 * 5 = 2 * N)
```

Le seul point nouveau méritant réflexion par rapport au cas $N = 4$ provient ici de l'imparité du nombre de sorties. On décidera ainsi de ne pas inverser les 10 séquences du type 2 à savoir 00011 bien que le résultat en serait un JTR accrû ($3 \div 5 = 60$ % au lieu de $2 \div 5 = 40$ %) car si on le faisait, on obtiendrait le même type de séquence finale (en tenant compte du fil 29) :

111000 au lieu de 000111.

Cette remarque permet de réduire le nombre de circuits de $(2 ! 5) = 10$ à savoir $(1 ! 5) = 5$ pour un même résultat global réellement obtenu (KRT et non JTR).

Effectués par analogie avec le cas $N = 4$, les calculs sont résumés sur le tableau IX.

Tableau IX

```
Δpin  =  (1÷5) =  (20% ,
TC    =  (1!5) ÷ (5+1) = 0 . 8 circuit/pin ,
mJTR  =  40% et 73% SJ(N) ont un
JTR   ≥  60% >  50% avec une moyenne
µJTR  =  63% ;
mKTR  =  50%  et 100% SK(N) ont un
KTR   ≥  50%  avec une moyenne
µKTR  =  66% .
```

Là encore, le paramètre $\Delta$pin, trop élevé, limite l'utilisation de ce cas à quelques faisceaux isolés seulement !

Si ABCDE sont les signaux sur les fils 22-1 à 22-N, le signal de commande inversion/transmission sera obtenu en personnalisant le circuit PLA de façon qu'il réalise la fonction suivante :

$$\overline{IT} = \bar{A}\,\bar{B}\,\bar{C}\,\bar{D} + \bar{A}\,\bar{B}\,\bar{C}\,\bar{E} + \bar{A}\,\bar{B}\,\bar{D}\,\bar{E} + \bar{A}\,\bar{C}\,\bar{D}\,\bar{E} + \bar{B}\,\bar{C}\,\bar{D}\,\bar{E}$$

Traitement normal des cas $N = 8$ ou $9$ :

On va voir que deux cas semblent réaliser l'optimum recherché. Les deux tableaux X et XI résument l'étude du cas $N = 8$. Pour ce cas, l'ensemble des KTR est à son maximum cependant que les deux paramètres $\Delta$pin et TC sont très proches des limites acceptables.

Les deux tableaux XII et XIII résument l'étude du cas $N = 9$. On voit immédiatement que le taux de circuit est trop élevé ! En conséquence, pour le cas $N = 9$, on fera une étape supplémentaire en opérant un compromis, on cherchera à diminuer le nombre de circuits nécessaires au bloc 25, ce faisant, on diminuera corrélativement le maximum de $\mu$KTR que l'on puisse atteindre : l'étude correspondante est résumée sur les tableaux XIV et XV. La comparaison des tableaux XIII et XV montre clairement qu'on n'a

12

pratiquement rien perdu en μKTR, c'est-à-dire en TR global et statistique, pour néanmoins une amélioration très importante en décompte de circuits, lequel décompte reste cette fois dans une limite acceptable.

Tableau X

CAS : N = 8

```
            A B C D   E F G H

(8!8) =   1 : 1 1 1 1  1 1 1 1 ,  1  1 1 1 1  1 1 1 1

(7!8) =   8 : 0 1 1 1  1 1 1 1 ,  1  0 1 1 1  1 1 1 1

(6!8) =  28 : 0 0 1 1  1 1 1 1 ,  1  0 0 1 1  1 1 1 1

(5!8) =  56 : 0 0 0 1  1 1 1 1 ,  1  0 0 0 1  1 1 1 1

(4!8) =  70 : 0 0 0 0  1 1 1 1 ,  1  0 0 0 0  1 1 1 1

(3!8) =  56 : 0 0 0 0  0 1 1 1 ,  0  1 1 1 1  1 0 0 0

(2!8) =  28 : 0 0 0 0  0 0 1 1 ,  0  1 1 1 1  1 1 0 0

(1!8) =   8 : 0 0 0 0  0 0 0 1 ,  0  1 1 1 1  1 1 1 0

(0!8) =   1 : 0 0 0 0  0 0 0 0 ,  0  1 1 1 1  1 1 1 1

          256 = 2 x 8 = 2 x N.
```

Le circuit PLA est personnalisé conformément à la formule :

$$\overline{\Pi} = \bar{A}\,\bar{B}\,\bar{C}\,\bar{D}\,\bar{E} + \bar{A}\,\bar{B}\,\bar{C}\,\bar{D}\,\bar{F} + \dots + \bar{D}\,\bar{E}\,\bar{F}\,\bar{G}\,\bar{H}$$

somme de 56 produits logiques.

Tableau XI

```
Δpin  =  (1÷8)    ≃  13% ,

TC    =  (3!8) ÷ (8+1) ≃ 6 circuit/pin,

mJTR  =  50%   donc 100% SJ(N) ont un

JTR   ≥  50%   avec une moyenne

μJTR  =  64% ;

mKTR  =  56%   donc  100% SK(N) ont un

KTR   ≥  56%  >  50% avec une moyenne

μKTR  =  64% .
```

## Tableau XIII

### CAS N = 9

```
            A B C   D E F   G H I

(9!9) =   1 : 1 1 1  1 1 1  1 1 1 ,  1  1 1 1  1 1 1  1 1 1

(8!9) =   9 : 0 1 1  1 1 1  1 1 1 ,  1  0 1 1  1 1 1 .1 1 1

(7!9) =  36 : 0 0 1  1 1 1  1 1 1 ,  1  0 0 1  1 1 1  1 1 1

(6!9) =  84 : 0 0 0  1 1 1  1 1 1    1  0 0 0  1 1 1  1 1 1

(5!9) = 126 : 0 0 0  0 1 1  1 1 1 ,  1  0 0 0  0 1 1  1 1 1

(4!9) = 126 : 0 0 0  0 0 1  1 1 1 ,  1  0 0 0  0 0 1  1 1 1

(3!9) =  84 : 0 0 0  0 0 0  1 1 1 ,  0  1 1 1  1 1 1  0 0 0

(2!9) =  36 : 0 0 0  0 0 0  0 1 1 ,  0  1 1 1  1 1 1  1 0 0

(1!9) =   9 : 0 0 0  0 0 0  0 0 1 ,  0  1 1 1  1 1 1  1 1 0

(0!9) =   1 : 0 0 0  0 0 0  0 0 0 ,  0  1 1 1  1 1 1  1 1 1
            ___

       512 =  2 ✶ 9  =  2 ✶ N
```

Le circuit PLA est personnalisé conformément à la formule :

$$\overline{\Pi} = \bar{A}\,\bar{B}\,\bar{C}\,\bar{D}\,\bar{E}\,\bar{F} + \bar{A}\,\bar{B}\,\bar{C}\,\bar{D}\,\bar{E}\,\bar{G} + \dots \bar{D}\,\bar{E}\,\bar{F}\,\bar{G}\,\bar{H}\,\bar{I}$$

somme des 84 produits logiques.

### Tableau XIII

```
Δpin = (1÷9) ≃  11%

TC   = (3!9) ÷ (9+1) ≃ 8 circuit/pin,

mJTR = 44% et 75% SJ(N) ont un

 JTR ≥ 56% > 50% avec une moyenne

µJTR = 61% ;

mKTR = 50% donc 100% SK(N) ont un

 KTR ≥ 50%,  avec une moyenne
µKTR ≃ 62%
```

Tableau XIV

CAS N = 9 (deuxième possibilité)

```
(9!9) =   1 : 1 1 1   1 1 1   1 1 1 ,   1   1 1 1   1 1 1   1 1 1
(8!9) =   9 : 0 1 1   1 1 1   1 1 1 ,   1   0 1 1   1 1 1   1 1 1
(7!9) =  36 : 0 0 1   1 1 1   1 1 1 ,   1   0 0 1   1 1 1   1 1 1
(6!9) =  84 : 0 0 0   1 1 1   1 1 1 ,   1   0 0 0   1 1 1   1 1 1
(5!9) = 126 : 0 0 0   0 1 1   1 1 1 ,   1   0 0 0   0 1 1   1 1 1
(4!9) = 126 : 0 0 0   0 0 1   1 1 1 ,   1   0 0 0   0 0 1   1 1 1
(3!9) =  84 : 0 0 0   0 0 0   1 1 1 ,   1   0 0 0   0 0 0   1 1 1
(2!9) =  36 : 0 0 0   0 0 0   0 1 1 ,   0   1 1 1   1 1 1   1 0 0
(1!9) =   9 : 0 0 0   0 0 0   0 0 1 ,   0   1 1 1   1 1 1   1 1 0
(0!9) =   1 : 0 0 0   0 0 0   0 0 0 ,   0   1 1 1   1 1 1   1 1 1
          ___
          512 =    2 * 9   = 2 * N
```

Le circuit PLA est personnalisé conformément à la formule :

$$\overline{\text{IT}} = \bar{A}\,\bar{B}\,\bar{C}\,\bar{D}\,\bar{E}\,\bar{F}\,\bar{G} + \bar{A}\,\bar{B}\,\bar{C}\,\bar{D}\,\bar{E}\,\bar{F}\,\bar{H} + \dots + \bar{C}\,\bar{D}\,\bar{E}\,\bar{F}\,\bar{G}\,\bar{H}\,\bar{I}$$

somme de 36 produits logiques.

Tableau XV

```
Δpin  = (1÷9) = 11% ,
TC    = (2!9) ÷ (9+1) ≃ 4 circuit/pin
mJTR  = 33% et 59% SJ(N) ont un
JTR   ≥ 56% > 50% avec une moyenne
μJTR  = 55% ;
mKTR  = 40% et 84% SK(N) ont un
KTR   ≥ avec une moyenne
μKTR  = 59% .
```

En définitive, puisqu'à l'unité d'information reste l'octet (avec ou sans parité), chaque fois qu'on aura un BUS de données à transmettre si ce BUS ne comporte pas de parité, on le subdivisera en faisceaux de 8 bits et on appliquera à chaque faisceau la transformation résumée sur les tableaux X et XI ; et chaque fois que le bus à transmettre sera muni d'une parité (1 bit de parité par octet), on le subdivisera en faisceaux de 9 bits et on appliquera à chacun de ces faisceaux la transformation résumée sur les tableaux XIV et XV.

De part cette méthode, on est assuré de réaliser un optimum entre les paramètres :
Δpin,
TC et
μKTR.

## Revendications

1. Procédé pour transmettre N signaux logiques entre deux microplaquettes de circuits intégrés, la microplaquette émettrice comportant au moins N bornes de sortie et au moins un ensemble de circuits logiques ayant N sorties sur lesquelles il(s) génère(nt) les signaux logiques à transmettre de telle sorte que sur chacune desdites sorties le niveau logique du signal dépend de l'état conducteur ou bloqué d'un élément semi-conducteur et la microplaquette réceptrice comportant au moins N bornes d'entrée, caractérisé en ce qu'il comprend :

l'analyse de la configuration des niveaux logiques sur les N sorties du (des) ensemble(s) de circuits logiques pour générer une commande d'inversion si le nombre des niveaux logiques fournis par des éléments semi-conducteurs mis à l'état conducteur est supérieur à un nombre prédéterminé égal ou supérieur au nombre de niveaux logiques fournis par des éléments semi-conducteurs mis à l'état bloqué et pour générer une commande de transmision dans le cas contraire,

l'inversion de la configuration des signaux logiques fournis aux sorties du (des) ensembles de circuits logiques et la transmission de cette configuration inversée aux entrées de la microplaquette réceptrice en réponse à la commande d'inversion,

la transmission directe de la configuration des signaux logiques fournis aux sorties du (des) ensemble(s) des circuits logiques, aux entrées de la microplaquette réceptrice en réponse à la commande de transmission.

2. Procédé selon la revendication 1 caractérisé en ce qu'il comprend la transmission des commandes d'inversion et de transmission à la microplaquette réceptrice et l'inversion des signaux qu'elle reçoit sous contrôle de la commande d'inversion.

3. Dispositif pour transmettre N signaux logiques entre deux microplaquettes de circuits intégrés, la microplaquette émettrice comportant au moins N bornes de sortie et au moins un ensemble de circuits logiques ayant N sorties sur lesquelles il(s) génèr(ent) les signaux logiques à transmettre de telle sorte que sur chacune desdites sorties le niveau logique du signal à transmettre dépend de l'état conducteur ou bloqué d'un élément semi-conducteur et la microplaquette réceptrice comportant au moins N bornes d'entrée, caractérisé en ce qu'il comprend :

un moyen (25) pour générer un signal de commande d'inversion/transmission ayant N entrées, chaque entrée étant connectée à une sortie (22-1 à 22-N) du (des) ensemble(s) de circuits logiques et une sortie sur laquelle est généré un signal de commande d'inversion lorsque le nombre des niveaux logiques fournis par des éléments semi-conducteurs mis à l'état conducteur est supérieur à un nombre prédéterminé égal ou supérieur au nombre de niveaux logiques fournis par des éléments semi-conducteurs mis à l'état bloqué et pour générer un signal de commande de transmission dans le cas contraire,

N circuits d'attaque à inversion contrôlée (24-1 à 24-N) ayant chacun une entrée de données connectée à une borne (22-1 à 22-N) du (des) ensemble(s) de circuits logiques et une entrée de commande recevant le signal de sortie du moyen pour générer le signal de commande d'inversion/transmission, et une sortie connectée à une des bornes de sortie de la microplaquette émettrice sur laquelle le signal de l'entrée de données se retrouve inversé ou non suivant l'état du signal de commande.

4. Dispositif selon la revendication 3 caractérisé en ce qu'il comprend :

N liaisons électriques (28-1 à 28-N) chacune ayant une entrée connectée à une sortie d'un circuit d'attaque et une sortie connectée à une entrée de la microplaquette réceptrice,

une (N + 1)ème liaison électrique (27, 29, 31) ayant une entrée connectée à la sortie du circuit de génération du signal de commande d'inversion/transmission,

N circuits récepteurs à inversion contrôlée, (30-1 à 30-N) chacun ayant une entrée de données connectée à la sortie d'une des N liaisons électriques, et une entrée de commande connectée à la sortie de la (N + 1)ème liaison électrique et une sortie sur laquelle le signal sur l'entrée de données se retrouve inversé ou non suivant l'état du signal de commande.

5. Dispositif selon la revendication 3 ou 4 caractérisé en ce que le nombre prédéterminé est égal à N/2 si N est pair et à (N + 1)/2 si N est impair.

6. Dispositif selon la revendication 4 ou 5 caractérisé en ce que le circuit de génération du signal de commande d'inversion/transmission comprend un amplificateur différentiel ayant deux entrées, la première étant connectée par des résistances de sommation aux N sorties (22-1 à 22-N) du (des) ensemble(s) de circuits logiques et la seconde étant connectée à la sortie d'un générateur de tension (42) générant une tension qui est voisine de celle présente sur la première borne d'entrée lorsque sur lesdites sorties le nombre des niveaux logiques fournis par des éléments semi-conducteurs mis à l'état conducteur est égal si N est pair ou supérieur de 1 si N est impair au nombre de niveaux logiques fournis par des éléments semi-conducteurs mis à l'état bloqué.

7. Dispositif selon l'une quelconque des revendications 3 ou 4 caractérisé en ce que le moyen pour générer le signal de commande d'inversion/transmission est un circuit logique du type PLA (Programme Logic Array).

8. Dispositif selon l'une quelconque des revendications 3 à 7 caractérisé en ce que les éléments semi-conducteurs fournissant les niveaux logiques des signaux à transmettre sont des transistors dont les bases sont contrôlées par les circuits intégrés de la microplaquette émettrice, les sorties fournissant les signaux à transmettre étant prises aux collecteurs desdits transistors.

9. Dispositif selon l'une quelconque des revendications 3 à 8 caractérisé en ce que les circuits d'attaque à inversion contrôlée sont des circuits OU Exclusifs.

10. Dispositif selon la revendication 6 caractérisé en ce que la microplaquette comporte plusieurs ensembles logiques ayant chacun N sorties, un signal de commande d'inversion/transmission étant associé à chacune des N sorties, et fourni sur une borne de sortie de la microplaquette, l'état dudit signal étant pris en compte pour que dans la configuration de niveaux logiques sur les (N + 1) bornes de sortie y compris la borne de sortie sur laquelle est généré ledit signal de commande, le nombre des niveaux logiques correspondant à un nombre d'éléments semi-conducteurs conducteurs, soit inférieur à celui des niveaux logiques correspondant à un nombre d'éléments semi-conducteur bloqués.

## Claims

1. A process for transmitting N logic signals between two integrated circuit chips, the transmitting chip having at least N output terminals and at least one assembly of logic circuits with N outputs upon which it (they) generates the logic signals to be transmitted so that the logic level of the signal is, on each of said outputs, dependent on the ON or OFF state of a semiconductor element, and the receiving chip having at least N input terminals, characterized in that it includes ;

analysing the configuration of the logic levels on the N outputs of the assembly(ies) of logic circuits in order to generate an invert control when the number of the logic levels supplied by turned ON semiconductor elements is larger than a predetermined number equal to or larger than the number of the logic levels supplied by turnerd OFF semiconductor elements, and to generate a pass control in the opposite case,

inverting the configuration of the logic signals supplied at the outputs of the assembly(ies) of logic circuits, and passing said inverted configuration to the inputs of the receiving chip in response to the invert control,

transmitting directly the configuration of the logic signals supplied at the outputs of the assembly(ies) of the logic circuits, to the inputs of the receiving chip in response to the pass control.

2. A process according to claim 1, characterized in that it includes transmitting the invert and pass controls to the receiving chip, and inverting the signals it receives under the control of the invert control.

3. A device for the transmission of N logic signals between two integrated circuit chips, the transmitting chip having at least N output terminals and at least one assembly of logic circuits with N outputs upon which it (they) generates the logic signals to be transmitted so that the logic level of the signal to be transmitted is, on each of said ouputs, dependent on the ON or OFF state of a semiconductor element, and the receiving chip having at least N input terminals, characterized in that it includes :

a generating means (25) for generating a pass/invert control signal provided with N inputs, each of said inputs being connected to one output (22-1 through 22-N) of the assembly (ies) of the logic circuits, and/with one output which receives an invert control signal when the number of the logic levels supplied by turned ON semiconductor elements is larger than a predetermined number equal to or larger than the number of the logic levels supplied by the turned OFF semiconductor elements, and for generating a pass control signal in the opposite case,

N controlled-invert driver circuits (24-1 through 24-N) having, each, one data input connected to a terminal (22-1 through 22-N) of the assembly (ies) of logic circuits, and one control input receiving the output signal of said generating means for generating the pass/invert control signal, and one output connected to one of the output terminals of the transmitting chip on which the data input signal is either inverted or not depending on the state of the control signal.

4. A device according to claim 3, characterized in that it includes :

N electrical connections (28-1 through 28-N) having, each, one input connected to an output of a driver circuit, and one output connected to an input of the receiving chip,

a $(N + 1)^{th}$ electrical connection (27, 29, 31) having an input connected to the output of the circuit for generating the pass/invert control signal,

N-controlled-invert receiving circuits (30-1 through 30-N) having, each, one data input connected to the output of one of the N electrical connections, and one control input connected to the output of the (N + 1) the electrical connection, and one output on which the signal at the data input appears inverted or not depending on the level of the control signal.

5. A device according to claim 3 or claim 4, characterized in that the predetermined number is equal to N/2 when N is even and to (N + 1)/2 when N is odd.

6. A device according to claim 4 or claim 5, characterized in that the generating circuit for generating the pass/invert control signal includes a two-input differential amplifier the first input being connected to the N outputs (22-1 through 22-N) of the assembly (ies) of the logic circuits, through summing resistors, and the second input being connected to the output of a voltage generator (42) generating a voltage of an amplitude which is about the one present on the first input temrinal when, on the output terminals, the number of the logic levels supplied by turned ON semiconductor elements is equal when N is even, or larger by 1, when N is odd, than the number of the logic levels supplied by turned OFF semiconductor elements.

7. A device according to any one of the claims 3 or 4, characterized in that the generating means for generating the invert/pass control signal is a logic circuit of the PLA type (Programmable Logic Array).

8. A device according to any one of the claims 3 through 7, characterized in that the semiconductor element supplying the logic levels of the signals to betransmitted are transistors the bases of which are controlled by the integrated circuits of the transmitting chip, the outputs supplying the signals to be transmitted being taken at the collectors of said transistors.

9. A device according to any one of the claims 3 through 8, characterized in that the controlled-invert driver circuits are Exclusive OR circuits.

10. A device according to claim 6, characterized in that the chip includes a plurality of logic assemblies having, each, N outputs, a pass/invert control signal being associated with each of the N outputs, and applied to an output termianl of the chip, the state of said signal being considered so that, in the configuration of the logic levels on the (N + 1) output terminals including the output terminal upon which said control signal is generated, the number of the logic levels corresponding to a number of ON semiconductor elements, is lower than the number of the logic levels corresponding to a nubmer of OFF state semiconductor elements.

## Patentansprüche

1. Verfahren zum Übertragen von N logischen Signalen zwischen zwei Mikrochips von integrierten Schaltungen, wobei der Emittermikrochip mindestens N Ausgangsklemmen und mindestens einen Satz von Verknüpfungsschaltungen mit N Ausgängen aufweist, an den ein oder mehrere Sätze von Verknüpfungsschaltungen logische Signale anlegen, so dass an jedem logischen Ausgang der logische Pegel des Signals durch den leitenden oder gesperrten Zustand des Halbleiterelementes bedingt ist, und wobei der Empfangsmikrochip mindestens N Eingangsklemmen aufweist, dadurch gekennzeichnet, dass das Verfahren einschliesst :

die Analyse der Schaltungsart der an den N Ausgängen des oder der Sätze von Verknüfungsschaltungen erscheinenden logischen Pegel zur Erzeugung eines Steuersignals für Umkehrung, wenn die Anzahl der logischen von den leitend gewordenen Halbleiterelementen gegebenen Pegel höher als eine vorbestimmte Anzahl ist, die gleich oder höher als die Anzahl der logischen von den gesperrt gewordenen Halbleiterelementen gegebenen Pegel ist, und in dem anderen Fall zur Erzeugung eines Steuersignals für Übertragung,

die Umkehrung der Schaltungsart der logischen an den Ausgängen des oder der Sätze von Verknüpfungsschaltungen gelegten Signale und die Übertragung dieser umgekehrten Schaltungsart an den Eingängen des Empfangsmikrochips im Ansprechen auf die Umkehrung,

die unmittelbare Übertragung der Schaltungsart der logischen an den Ausgängen des oder der Sätze von Verknüpfungsschaltungen auftretenden Signale an die Eingänge des Empfangsmikrochips im Ansprechen auf das Steuersignal für Übertragung.

2. Verfahren nach Anspruch 1, dadurch gekennzeichnet, dass es die Übermittlung der Steuersignale für Umkehrungen und Übertragungen an den Empfangsmikrochip und die Umkehrung der unter Steuerung des Umkehrungssignals von ihr empfangenen Signale aufweist.

3. Vorrichtung zum Übertragen von N logischen Signalen zwischen zwei Mikrochips von integrierten Schaltungen, wobei der Empfangsmikrochip mindestens N Ausgangsklemmen und mindestens einen Satz von Verknüpfungsschaltungen mit N Ausgängen aufweist, an den der oder die Sätze von Verknüpfungsschaltungen die zu übertragenden Signale erzeugen, so dass der logische bei je den Ausgängen erscheinende Pegel des zu übertragenden Signals durch den leitenden oder gesperrten Zustand des Halbleiterelementes bedingt ist, und wobei der Empfangsmikrochip mindestens N Eingangsklemmen aufweist, dadurch gekennzeichnet, dass die Vorrichtung einschliesst :

ein Mittel (25) zur Erzeugung eines Steuersignals für Umkehrung/Übertragung mit N Eingängen, wobei jeder Eingang mit einem Ausgang (22-1 bis 22-N) des oder der Sätze von Verknüpfungsschaltungen und mit einem Ausgang verbunden ist, an dem ein Umkehrungssignal erzeugt ist, wenn die Anzahl der logischen von den leitend gewordenen Halbleiterelementen gegebenen Pegel höher als eine vorbestimmte Anzahl ist, die gleich oder höher als die Anzahl der logischen von den gesperrt gewordenen Halbleiterelementen gegebenen Pegel ist, und in dem anderen Fall zur Erzeugung eines Übertragungssignals,

N Treiberschaltungen mit gesteuerter Umkehrung (24-1 bis 24-N), wobei jede Treiberschaltung einen mit einer Klemme (22-1 bis 22-N) des oder der Sätze von logischen Schaltungen verbundenen Dateneingang und einen Steuereingang zum Empfang des Ausgangssignals aus dem Mittel zur Erzeugung des Steuersignals für Umkehrung/Übertragung und auch einen mit einer der Ausgangsklemmen des Emittermikrochips verbundenen Ausgang aufweist, an dem das dem Dateneingang zugeführten Signal dem Zustand des Steuersignals entsprechend umgekehrt oder nicht gelegt ist.

4. Vorrichtung nach Anspruch 3, dadurch gekennzeichnet, dass sie einschliesst :

N elektrische Anschlüsse (28-1 bis 28-N), wobei jeder Anschluss einen mit einem Ausgang der Treiberschaltung verbundenen Eingang und einen mit einem Eingang des Empfangsmikrochips verbundenen Ausgang aufweist,

einen $(N + 1)^{ten}$ elektrischen Anschluss (27, 29, 31) mit einem mit dem Ausgang der Schaltung zur Erzeugung des Steuersignals für Umkehrung/Übertragung verbundenen Eingang,

N Empfangsschaltungen mit gesteuerter Umkehrung (30-1 bis 30-N), wobei jede Empfangsschaltung einen mit dem Ausgang eines der N elektrischen Anschlüsse verbundenen Dateneingang und einen mit dem Ausgang des $(N + 1)^{ten}$ elektrischen Anschlusses verbundenen Steuereingang und nach einen Ausgang aufweist, an dem das dem Dateneingang zugeführte Signal dem Zustand des Steuersignals entsprechend umgekehrt oder nicht gelegt ist.

5. Vorrichtung nach Anspruch 3 oder 4, dadurch gekennzeichnet, dass die vorbestimmte Anzahl gleich N/2, wenn N eine gerade Zahl ist, und gleich $(N + 1)/2$ ist, wenn N eine ungerade Zahl ist.

6. Vorrichtung nach Anspruch 4 oder 5, dadurch gekennzeichnet, dass die Schaltung zur Erzeugung des Steuersignals für Umkehrung/Übertragung einen Differenzverstärker mit zwei Eingängen aufweist, wobei der erste Eingang mit den Summierwiderständen über die N Ausgänge (22-1 bis 22-N) des oder der Sätze von Verknüpfungsschaltungen und der zweite Eingang mit dem Ausgang eines Spannungserzeugers (42) verbunden ist, wobei dieser Spannungserzeuger eine Spannung abgibt, die an der Grenze der an der ersten Eingangsklemme angelegten Spannung liegt, wenn an den Ausgängen die Anzahl der logischen von den leitend gewordenen Halbleiterelementen gegebenen Pegel gleich der Anzahl der logischen von den gesperrt gewordenen Halbleiterelementen gegebenen Pegel, wenn N eine gerade Zahl ist, oder höher um eins ist, wenn N eine ungerade Zahl ist.

7. Vorrichtung nach irgendeinem der Ansprüche 3 oder 4, dadurch gekennzeichnet, dass das Mittel zur Erzeugung des Steuersignals für Umkehrung/Übertragung eine logische Schaltung des Typs PLA (programmierbare logische Anordnung) ist.

8. Vorrichtung nach irgendeinem der Ansprüche 3 bis 7, dadurch gekennzeichnet, dass die Halbleiterelemente, die die logischen Pegel der zu übertragenden Signale geben, Transistoren mit von den integrierten Schaltungen des Emittermikrochips gesteuerten Basen sind, wobei die Ausgänge, die die zu übertragenden Signale liefern, bei den Kollektoren dieser Transistore abgenommen sind.

9. Vorrichtung nach irgendeinem der Ansprüche 3 bis 8, dadurch gekennzeichnet, dass die Treiberschaltungen mit gesteuerten Umkehrung Exklusiv-ODER-Verknüfungsschaltungen sind.

10. Vorrichtung nach Anspruch 6, dadurch gekennzeichnet, dass der Mikrochip mehrere logische Sätze je mit N Ausgängen aufweist, wobei ein Steuersignal für Umkehrung/übertragung mit je den N Ausgängen verbunden ist und der Ausgangsklemme des Mikrochips zugeführt ist, wobei der Zustand des Signals so in Rücksicht genommen ist, dass in der Schaltungsart der logischen Pegel an den Ausgangsklemmen $(N + 1)$ einschliesslich der Ausgangsklemme, an der das Befehlssignal erzeugt ist, die einer Anzahl von leitenden Halbleiterelementen entsprechende Anzahl der logischen Pegel kleiner als die einer Anzahl von gesperrten Halbleiterelementen entsprechende Anzahl der logischen Pegel ist.

0 069 183

FIG.1

FIG.2

FIG.3

FIG.4

FIG.5